(19) Europäisches Patentamt
European Patent Office
Office européen des brevets

(11) **EP 2 869 075 A1**

(12) **EUROPEAN PATENT APPLICATION**

(43) Date of publication:
06.05.2015 Bulletin 2015/19

(51) Int Cl.:
*G01R 31/02* (2006.01)   *B60L 3/04* (2006.01)
*H02J 7/00* (2006.01)

(21) Application number: **13191471.5**

(22) Date of filing: **04.11.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Raaijmakers, Stefan Joannes**
**2611 GZ Delft (NL)**
• **Koolen, Gerardus Johannes Karel Marijke**
**5735 GV Aarle Rixtel (NL)**

(74) Representative: **van Oeffelt, Abraham**
**Patentwerk B.V.**
**PO Box 1514**
**5200 BN 's-Hertogenbosch (NL)**

(54) **System and method for detecting a leakage from power cables of a DC bus to ground**

(57)    The present invention relates to a method for detecting a leakage from any of the power cables of a DC bus to a ground, in particular from the output connections of a charger for an electric vehicle to a ground, comprising the steps of superposing a stimulus current comprising at least one sinusoidal component to the charge current on the DC bus; measuring a response voltage on the bus; determining the impedance (capacitance and resistance) between the power cables and the ground based on a comparison of the superimposed stimulus current and the measured voltage and determining the presence of a ground fault when the determined resistance is lower than a predetermined or expected resistance. The invention further proposes a system for performing said method.

Figure 2 - Measurement method

**Description**

This invention relates to a system and method for detecting a leakage from power cables of a DC bus to ground.

For electric vehicles an emerging technology is to provide DC fast charging using an off-board charger. Common interface standards for this DC fast charging are CHAdeMO (from Japan), GB (Chinese) or the CCS standard (Combined Charging System, German/USA).

In all of these standards it is decided to have a floating galvanic isolated DC connection between charger and vehicle. To ensure that this isolation is safe before and during the charging process, an isolation monitor (or ground fault detector) is required in the charging station.

Since the new standard (according IEC 61851-23 and SAE J1772) requires that the charging station has a minimum resistance of 2.5M$\Omega$ for each of both DC conductors towards protective earth (PE), this isolation monitoring has become challenging. This because the charging station is not allowed to add less resistance than the mentioned 2.5M$\Omega$, may not use voltages higher than 60V for safety reasons and charger and vehicle combined may only add up to 5$\mu$F of capacitance to the bus. Within 10 seconds (with the CCS protocol) or even 1 second (with the CHAdeMO protocol) a ground fault must be detected. On top of this the isolation monitor must withstand unknown interference from the electric vehicle and outside sources.

The invention thereto proposes a method for detecting a leakage from any of the power cables of a DC bus to a ground, in particular from the output connections of a charger for an electric vehicle to a ground, comprising the steps of: Superposing a stimulus current comprising at least one sinusoidal component between the DC bus and the ground; measuring a response voltage on the bus with respect to ground; determining the impedance (capacitance and resistance) between the power cables and the ground based on a comparison of the superimposed stimulus current and the measured voltage; determining the presence of a leakage when the determined resistance is lower than a predetermined or expected resistance.

By adding a small sinusoidal stimulus current to the DC bus (with respect to PE), and correlate the measured voltage on the DC bus with the stimulus, the invention discloses an algorithm to measure a leakage resistance in a system with excess parallel capacitance and unknown interference, while introducing only an insignificant extra impedance for performing the measurement. This measurement is based on a stimulus/response measurement using quadrature correlation and tuned digital filtering.

In a further embodiment, measuring a response voltage on the bus comprises determining an amplitude attenuation of the measured voltage compared with the voltage caused by the stimulus current, and / or determining a phase shift of the measured voltage compared with the stimulus current.

A digital bandpass filter with defined phase at the stimulus frequency may be used, to filter interference out, but not to shift the phase of the intended stimulus signal. So called quadrature correlation may be used to derive amplitude and phase. A common method is to use a PLL for phase determination, but that is a slower method compared to the quadrature correlation method proposed by the present invention.

In a further embodiment, the method according to the invention comprises correlating the measured voltage with the stimulus current for suppressing non-correlating interference signals. Low pass filters with a notch on the double stimulus frequency may be used to enhance the measurement accuracy, while maintaining the speed of detection.

To reduce the noise, interference and measurement inaccuracies even more synchronous integrators, synchronised to the single or double stimulus frequency may be used. Switching may be done between slow and fast stimulus modes to be able to cover different standards, like CHAdeMO and CCS.

The invention further relates to a system for detecting a leakage from any of the poles of a DC bus to a ground, in particular from the output connections of a charger for an electric vehicle to a ground, comprising:

- a stimulus generator for generating a sinusoidal stimulus to the charge current on the poles of the DC bus;
- measuring means, for measuring a response voltage on the poles of the DC bus;
- Calculation means, such as a processor,

  o for calculating an impedance of the poles of the bus (capacitance and resistance) of the power cables, based on the sinusoidal stimulus and the response signal; and
  o for determining the presence of a leakage when the determined impedance is lower than a predetermined or expected impedance.

The calculation means comprise a band pass filter, for filtering the measured signal, the band pass filter being configured for suppressing side band interference and an offset component of the measured signal. Multiplication units, for multiplying the measured signal with the stimulus signal and for multiplying the measured signal with a 90 degrees phase shifted stimulus signal may further be present. In that case, a low pass filter for suppressing the double frequency of the stimulus signal may be applied too.

The measuring accuracy can be increased by applying synchronous integrators, synchronised to the single or double stimulus frequency, to integrate the multiplied low passed filter.

The invention will now be elucidated into more detail with reference to the following figures. Herein:

- Figure 1 shows a schematic view of a typical charging system;
- Figure 2 shows an electric scheme for performing the method according to the invention;
- Figure 3 shows a block diagram of the functionality of the scheme from figure 2; and
- Figure 4 shows signal values in the scheme from figure 2.

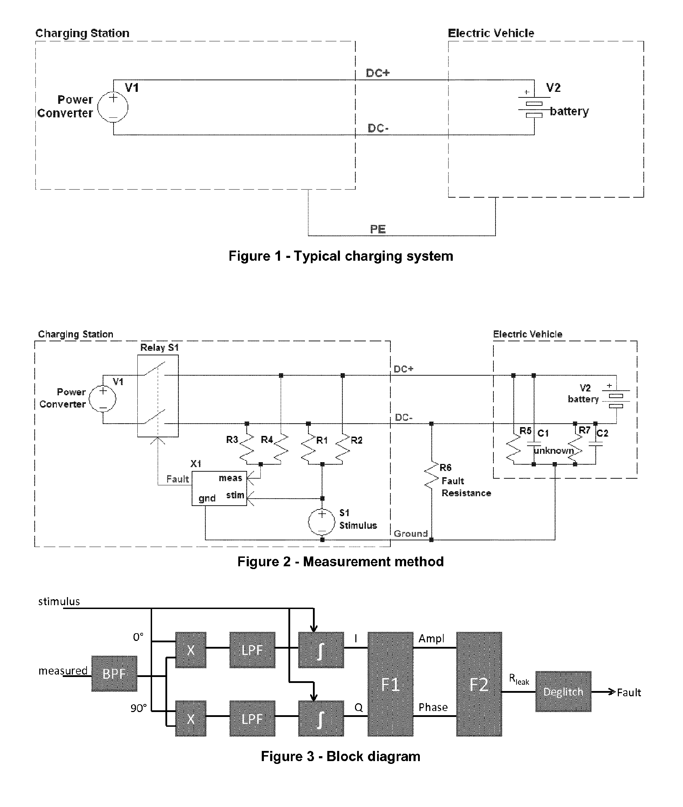

Figure 1 shows a schematic view of a typical charging system, wherein a power converter V1 is coupled to a battery V2 of an electric vehicle for charging the latter, by means of two power cables, DC+ and DC-.

Figure 2 shows an electric scheme for performing the method according to the invention.

R1 and R2 apply the stimulus to the DC bus, and R3 and R4 measure the response. Both with respect to ground. The response (measured voltage) is attenuated by the car impedances (R5,C1,R7,C2), but also by the fault resistance. These capacitances and resistances may appear on DC-, DC+ or both. So the amount of attenuation is a measure of the impedances on the DC bus which we want to detect. This is determined by correlating the measured voltage with the stimulus signal, in order to suppress (unknown, non-correlating) interference signals. This function is performed by the algorithm in X1.

In another embodiment, the values of the capacitors can be determined by:

$$C = Tan(phi) * (a+v) / (a*w*v) \quad (in \; Farad),$$

wherein w = omega = 2*pi*stimulusfrequency

This value can be determined for diagnosis purposes. Switching between frequencies can also be based on a determined capacity value:

If C> threshold: switch to SlowMode,
If C < threshold: switch to FastMode.

A vehicle that adds a large capacitance requires measurements in SlowMode because the capacitance is dominant in the measured attenuation with the stimulusfrequency of FastMode. If attenuation is dominated by the capacitance, the measurement of the resistance to ground becomes less accurate.

Figure 3 schematically shows the algorithm for the signal processing in block X1.

The following inputs are present: stimulus holds the 0° and 90° (sine and cosine) signals that are in phase with the applied signal. Also present is the measured signal which has an unknown attenuation. This algorithm is implemented in the digital domain (FPGA, DSP, MicroController) because of the filter accuracies.

Finally the deglitcher ("Deglitch" block in Figure 3) converts this measured resistance into a Boolean fault value, indicating that too many measurements where critically low.
There are different ways to implement this filter. A hysteresis can for instance be used.

A saturating counter can be used which is incremented by X when the measured resistance is below the threshold and decremented by Y when the measured resistance is above the threshold. When the counter reaches a predetermined level and saturates, the result will be set to True. When the counter reaches 0 and saturates, the result will be set to False. By selecting appropriate values for X, Y and the saturation level the sensitivity and reaction time of the deglitcher can be tuned.

To prevent switching back and forth between a True and False result when the measured resistance hovers around the trigger level, hysteresis can be added to the trigger level based on the True or False result. In this case once the measured resistance is determined to be below the trigger level, the result will switch to true and will only switch back to False when the measured resistance is above the trigger level plus a predetermined margin

The following program code forms a possible way to implement the deglitcher.

```
// input: Measured_Resistance holds measured resistance
// temp variable: CircularBuffer holds a defined number of recent elements
// output: OutputState holds filtered output state

If Measured_Resistance < FAULT_RESISTANCE
then Put "FAULT" in CircularBuffer
```

```
else Put "OKAY" in CircularBuffer
If count("FAULT" in CircularBuffer) > Threshold then OutputState = "FAULT"
If count("OKAY" in CircularBuffer) > Threshold then OutputState = "OKAY"
```

An additional technique is to switch to a different stimulus frequency when:

Too high capacitance level : switch to lower frequency
A faster response is required : switch to a higher frequency

For the CHAdeMO charging standard, a faster response time is required compared with the CCS (Combined charging system).
In each mode the above techniques apply. The filters are always tailored to the frequency being used.
Switching between modes is done preferably by observing the Amplitude signal. For a bi-mode system this means for example:

If in FastMode and Amplitude<AmplThreshold*90% then switch to SlowMode
If in SlowMode and Amplitude>AmplThreshold*110% then switch to FastMode

The switching between slow and fast stimulus modes is to be able to cover different standards, like CHAdeMO and CCS.

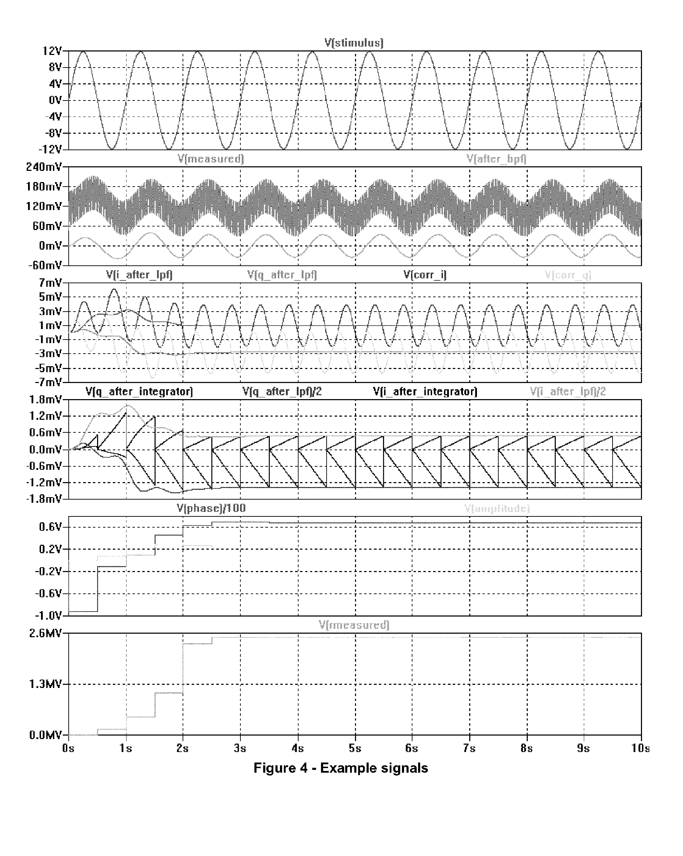

Figure 4 shows example signals. The applied stimulus is a sinusoidal signal V[stimulus]. The measured signal V[measured] is shifted in phase and has a lower amplitude due to the car impedances and fault resistance. It also contains additional interference signals, or noise. The bandpass filter (BPF) removes sideband interference as well as the offset. This is shown in V[after_BPF]. Then the filtered signal is fed into two multipliers: one multiplies with the sine and the other multiplies with the cosine variant of the stimulus signal. These result in respectively intensity V[corr_I] and quadrature V[corr_Q] signals.
Both are sinusoidal but their offsets contain the information we want. To measure these offsets, low pass filters (LPF) are used. These are shown as V[i_after_LPF] and V[q_after_LPF]. These two low pass filters also provide further interference filtering, and have the characteristic to have a notch at the double stimulus frequency, to suppress the sinusoidal waveform resulting from the multiplier and allow for faster settling than a usual low pass filter. The resulting signals have less ripple which eases operation for the integrators. The synchronous integrators determine the amount of energy within each halve cycle (halve because the frequency is doubled by the multipliers). These signals are shown as V[i_after_integration] and V[q_after_integration]. This integration makes the I and Q readout significantly more precise.
F1 (from Figure 3) holds the formulae to convert these into amplitude and phase signals. I and Q are treated as a vector:

$$\text{Phase}=-\text{atan}\,(Q/I)-k1 \hspace{4cm} (1)$$

$$\text{Amplitude}=k2*\sqrt{(I\char94 2+Q\char94 2\,)} \hspace{4cm} (2)$$

The constants k1 and k2 are tuned for Phase and Amplitude to be 0 and 1 respectively in an open (un-attenuated) system.
Example signals are shown in Figure 4 as "amplitude" and "phase" (yellow and purple).
F2 (from Figure 3) holds the formula to convert the Amplitude and Phase signals into a parallel resistance and capacitance:

$$R\_Leak=(-a⟦ v⟧^2 -a\ v^2\ ⟦Tan(phi)⟧^2 -\sqrt{(a^2\ v^2 +a^2\ v^2\ ⟦Tan(phi)⟧^2\ ))}/(-$$

$$1+v^2 +v^2\ ⟦Tan(phi)⟧^2\ )\qquad (in\ \Omega)$$

where:

a =     series stimulus resistor (R1* R2/(R1+R2)) in the above figure
v =     detected amplitude
phi =   detected phase shift

An example signal is shown in Figure 4 as V[rmeasured].
Besides the embodiments shown there are multiple embodiments thinkable, all falling within the scope of the present invention as defined in the following claims.

## Claims

1.   Method for detecting a leakage resistance from any of the power cables of a DC bus to a ground, in particular from the output connections of a charger for an electric vehicle to a ground, comprising the steps of:

   - Superposing a stimulus current comprising at least one sinusoidal component between the DC bus and the ground;
   - Measuring a response voltage on the bus with respect to ground;
   - Determining the impedance (capacitance and resistance) between the power cables and the ground based on a comparison of the superimposed stimulus current and the measured voltage;
   - Determining the presence of a leakage when the determined resistance is lower than a predetermined or expected resistance.

2.   Method according to claim 1, wherein measuring a response voltage on the bus comprises determining an amplitude attenuation of the measured voltage compared with the stimulus current.

3.   Method according to claim 1 or 2, wherein the step of correlating the measured voltage comprises determining a phase shift of the measured voltage compared with the stimulus current.

4.   Method according to any of the preceding claims, comprising:

   - correlating the measured voltage with the stimulus current for suppressing non-correlating interference signals.

5.   System for detecting a leakage resistance from any of the poles of a DC bus to a ground, in particular from the output connections of a charger for an electric vehicle to a ground, comprising:

   - a stimulus generator for generating a sinusoidal stimulus current between the poles of the DC bus and the ground;
   - measuring means, for measuring a response voltage on the poles of the DC bus with respect to ground;
   - Calculation means, such as a processor,

      o for calculating an impedance of the poles of the bus (capacitance and resistance) of the power cables, based on the sinusoidal stimulus and the response signal; and
      o for determining the presence of a leakage resistance when the determined resistance is lower than a predetermined or expected resistance.

6. System according to claim 5, wherein the calculation means comprise a band pass filter, for filtering the measured signal, the band pass filter being configured for suppressing side band interference and an offset component of the measured signal.

7. System according to claim 5 or 6 comprising a first multiplication unit, for multiplying the measured signal with the stimulus signal.

8. System according to claim 7 comprising a second multiplication unit, for multiplying the measured signal with a 90 degrees phase shifted stimulus signal.

9. System according to claim 7 or 8, comprising a low pass filter for each of the multiplied signals, the low pass filter being arranged for suppressing the double frequency of the stimulus signal.

10. System according to claim 9, comprising synchronous integrators synchronised to the double stimulus frequency, to integrate the multiplied low passed filter.

11. System according to any of claims 5-10, configured to be able to switch a stimulus signal frequency between multiple frequency modes.

**Charging Station**

**Electric Vehicle**

DC+

Power
Converter

V1

+
_

+

V2

battery

DC-

PE

Figure 1 - Typical charging system

**Charging Station**

**Electric Vehicle**

Relay S1

Power
Converter

V1

+
_

DC+

R3  R4    R1  R2

DC-

R5 C1    R7 C2

V2
battery

+

unknown

X1

Fault

meas

gnd  stim

R6
Fault
Resistance

S1
Stimulus

Ground

Figure 2 - Measurement method

stimulus

0°

measured

BPF

X

LPF

∫

X

LPF

∫

I

Q

F1

Ampl

Phase

F2

$R_{leak}$

Deglitch

Fault

90°

Figure 3 - Block diagram

Figure 4 - Example signals

Europäisches
Patentamt

European
Patent Office

Office européen
des brevets

## EUROPEAN SEARCH REPORT

Application Number

EP 13 19 1471

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2011 050590 A1 (SMA SOLAR TECHNOLOGY AG [DE]) 29 November 2012 (2012-11-29) * paragraphs [0001] - [0006], [0010], [0012] - [0022], [0028] - [0035]; claims 1,6-9,13,15,20-22; figures 1-3 * ----- | 1-11 | INV. G01R31/02 B60L3/04 H02J7/00 |
| X | US 4 896 115 A (LEMAITRE PHILIPPE [FR] ET AL) 23 January 1990 (1990-01-23) * column 1, lines 6-62; claims 1-5; figures 1,2,3A-3G * * column 2, line 62 - column 5, line 57 * ----- | 1-11 | |
| A | US 3 976 987 A (ANGER ERNEST G) 24 August 1976 (1976-08-24) * column 1, line 6 - column 2, line 46; figures 1,2 * * column 4, line 26 - column 13, line 52 * ----- | 1,5 | |
| | | | TECHNICAL FIELDS SEARCHED (IPC) G01R B60L H02J |

The present search report has been drawn up for all claims

| Place of search | Date of completion of the search | Examiner |
|---|---|---|
| Munich | 11 April 2014 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 19 1471

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2014

| Patent document cited in search report | Publication date | Patent family member(s) | | Publication date |
|---|---|---|---|---|
| DE 102011050590 A1 | 29-11-2012 | CN | 103547932 A | 29-01-2014 |
| | | DE | 102011050590 A1 | 29-11-2012 |
| | | EP | 2721423 A1 | 23-04-2014 |
| | | US | 2014097854 A1 | 10-04-2014 |
| | | WO | 2012160118 A1 | 29-11-2012 |
| US 4896115 A | 23-01-1990 | DE | 3882833 D1 | 09-09-1993 |
| | | DE | 3882833 T2 | 24-02-1994 |
| | | EP | 0297933 A1 | 04-01-1989 |
| | | ES | 2043866 T3 | 01-01-1994 |
| | | FR | 2616228 A1 | 09-12-1988 |
| | | US | 4896115 A | 23-01-1990 |
| US 3976987 A | 24-08-1976 | AU | 504535 B2 | 18-10-1979 |
| | | AU | 1435676 A | 01-12-1977 |
| | | CA | 1052864 A1 | 17-04-1979 |
| | | DE | 2630982 A1 | 10-03-1977 |
| | | FR | 2322378 A1 | 25-03-1977 |
| | | GB | 1552829 A | 19-09-1979 |
| | | IT | 1071198 B | 02-04-1985 |
| | | US | 3976987 A | 24-08-1976 |
| | | ZA | 7603055 A | 27-04-1977 |

EPO FORM P0459

For more details about this annex : see Official Journal of the European Patent Office, No. 12/82